(19) Europäisches Patentamt
European Patent Office
Office européen des brevets

(11) **EP 2 463 574 A1**

(12) **EUROPEAN PATENT APPLICATION**
published in accordance with Art. 153(4) EPC

(43) Date of publication:
**13.06.2012 Bulletin 2012/24**

(51) Int Cl.:
*F21S 8/08* (2006.01)          *F21V 13/04* (2006.01)
*F21Y 101/02* (2006.01)

(21) Application number: **10806320.7**

(22) Date of filing: **14.07.2010**

(86) International application number:
**PCT/JP2010/061880**

(87) International publication number:
**WO 2011/016320 (10.02.2011 Gazette 2011/06)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **07.08.2009 JP 2009184442**

(71) Applicant: **Konica Minolta Opto, Inc.
Hachioji-shi, Tokyo 192-8505 (JP)**

(72) Inventor: **ONO, Yuki
Hachioji-shi
Tokyo 192-8505 (JP)**

(74) Representative: **Henkel, Breuer & Partner
Patentanwälte
Maximiliansplatz 21
80333 München (DE)**

(54) **LED LIGHTING DEVICE, STREET LIGHT, AND OPTICAL SYSTEM FOR LED LIGHTING DEVICE**

(57)  A reflector has a reflection plane for reflecting light emitted from an LED light source in the direction that goes away from the optical axis of the LED light source with respect to the direction parallel to the optical axis, whereby the effective use of emitted light can be ensured by reflecting, for example, peripheral light, which normally cannot be effectively used, in a proper direction by the reflection plane and causing the reflected light to enter a diffusion lens. Further, by using the abovementioned reflection plane, the thickness of the reflector can be reduced and the diffusion effect of the emitted light can be increased, thereby enabling an increase in the flexibility of the design of the diffusion lens and a reduction in the thickness thereof, and consequently the thickness of an LED lighting device can be reduced.

FIG. 3

EP 2 463 574 A1

**Description**

**FIELD OF THE INVENTION**

The present invention relates to a LED (light emitting diode) lighting device, street light and optical system for LED lighting device, in particular, to a LED lighting device, street light and optical system for LED lighting device characterized by excellent light distribution.

**BACKGROUND OF THE INVENTION**

In recent years, a white LED of high brightness has been developed, and is expected to replace an incandescent light in the field of illumination because of reduced thickness, longer service life and power conservation effects. However, one of the problems found in the use of a white LED as a lighting device is that the illuminance is smaller than that of an incandescent light This problem can be solved by using a plurality of white LED's to meet the illuminance requirements.

When a white LED is used as a street light, the poor light distribution characteristic thereof raises a problem. Patent Literature 1 solves this problem by using a reflecting mirror wherein the cross section of the LED in the direction of optical axis is arch-shaped, in such a way that the light flux emitted from the LED will be converged so as to achieve the maximally possible uniformity in the distribution of light quantity.

**EARLIER TECHNOLOGICAL LITERATURE**

**PATENT LITERATURE**

Patent Literature 1: Unexamined Japanese Patent Application Publication No. 2008-130393

**SUMMARY OFTHE INVENTION**

However, the technology of Patent Literature 1 uses an arch-shaped reflecting mirror, which is characterized by an increased thickness of the lighting device in the direction of optical axis. This makes it difficult to utilize the advantage of using a considerably thin LED as compared to a light bulb and fluorescent light

Further, according to the study by the present inventor, the required light emitting properties of the lighting device required from the street lamp include enlargement of the illumination range and effective use of the outgoing light, rather than the uniformity in the distribution of light. When the Patent Literature 1 is viewed from the standpoint of meeting this requirement, it has been found out that, since the technology of Patent Literature 1 has a capability of converging light, the range of illumination is restricted to a smaller scope. When the Patent Literature 1 is to be modified to meet the aforementioned requirement, it may be possible to install a diffusion lends such as a concave lens in front of the reflecting minor. However, this requires the curvature of the concave lens to be increased, with the result that the thickness of the lighting device is increased in the direction of optical axis and the advantage of using the LED cannot be effectively utilized.

In view of the problems described above, it is an object of the present invention to provide a LED lighting device, street light and optical system for LED lighting device, wherein a slim structure can be designed by the use of a LED thinner than a lamp, and enlargement of the illumination range and effective use of the outgoing light are achieved

**MEANS FOR SOLVING THE PROBLEMS**

The LED lighting device according to Claim 1 includes: a LED light source; a reflector for reflecting the light emitted from this LED light source; and a diffusion lens for diffusing and emitting the light reflected by the reflector, wherein the reflector has a reflection plane for reflecting light emitted from an LED light source in the direction that goes away from the optical axis of the LED light source with respect to the direction parallel to the optical axis.

According to the present invention, the reflector has a reflection plane for reflecting light emitted from an LED light source in the direction that goes away from the optical axis of the LED light source with respect to the direction parallel to the optical axis. Thus, for example, the peripheral light that cannot be used effectively is reflected in the proper direction by the reflection plane and is made to enter the diffusion lens, whereby the effective use of the outgoing light can be ensured. Further, use of such a reflection plane allows the reflector to be designed in a slim structure and improves the diffusion effect ofthe outgoing light. This enhances the flexibility in the design of a diffusion lens and reduces the thickness thereof, so that an LED lighting device is designed in a slim structure. For example, the power for diffusing a light flux can be dispersed to the lens and reflector. This allows the curvature of the diffusion lens to be reduced, so that the diffusion lens is reduced in thickness. In the light source using an incandescent light, the incandescent light itselfis not a slim light source. Accordingly, there is a greater demand for the reduction in the thickness of the entire optical system. However, in the LED light source, the LED itself is a slim light source. Thus, there is a still greater demand for reduction in the thickness of the entire optical system. The present invention meets this demand and promotes a further reduction in the thickness of a LED lighting device.

The LED lighting device described in Claim 2 is the same as the invention according to Claim 1 except in that, the reflector has a reflection plane whose inclination in the direction perpendicular to the optical axis becomes less steep as one goes away from the LED light source in the direction perpendicular to the optical axis. This allows the thickness of the diffusion lens to be reduced.

The LED lighting device described in Claim 3 is the same as the invention according to Claim 1 or 2 except in that a roughened surface is formed between the LED lighting device and reflection plane. This arrangement enables the light emitted from the LED lighting device to be reduced. In particular when the LED light source is a white LED containing a blue LED and fluorophore, a serious problem is found in color irregularities. It is required to solve this problem to achieve the level as close as possible to the white light. This requirement can be met by formation of a roughened surface.

The LED lighting device described in Claim 4 is the same as the invention described in any one of the Claims 1 through 3 except in that the reflection plane is formed of a curved surface.

The LED lighting device described in Claim 5 is the same as the invention described in any one of the Claims 1 through 3 except in that the aforementioned reflection plane is formed of a combination of a plurality of plane surfaces.

The LED lighting device described in Claim 6 is the same as the invention described in any one of the Claims 1 through 5 except in that the aforementioned diffusion lens is a concave lens.

The LED lighting device described in Claim 7 is the same as the invention according to Claim 6 except in that the thickness of at least one of the reflector and concave lens in the direction of optical axis is 1 mm or more without exceeding 20 mm.

The street lamp described in Claim 8 includes a plurality of LED lighting devices described in any one of the Claims 1 through 7. The street lamp can be mounted on a pillar or on the ceiling or wall surface of a building or tunnel.

The optical system for the LED lighting device described in Claim 9 is an optical system used in the LED lighting device including a LED light source, a reflector for reflecting the light emitted from the LED light source, and a diffusion lens for diffusing and emitting the light reflected by the reflector. The optical system for the LED lighting device includes the aforementioned reflector and diffusion lens. The reflector has a reflection plane for reflecting light emitted from an LED light source in the direction that goes away from the optical axis of the LED light source with respect to the direction parallel to the optical axis.

The LED (light emitting diode) lighting device of the present invention includes a LED light source, a reflector for reflecting the light emitted from the LED light source, and a diffusion lens for diffusing and emitting the light reflected by the reflector. The optical system for the LED lighting device includes the reflector and diffusion lens without a LED light source.

Various types of light sources have been used as a LED light source. A white LED is preferably used as a street lamp.

The white LED preferably used is formed of a combination of a blue LED and a YAG fluorophore that produces a yellow color using the blue beam emitted from the blue LED chip. It is also possible to adopt a white LED that employs a combination of a blue LED chip, green LED chip and red LED chip to produce white light. For example, the white LED disclosed in the Unexamined Japanese Patent Application Publication No. 2008-231218 can be used, without the present invention being restricted thereto.

The reflector is intended to reflect the light emitted from the LED light source.

The reflector can be made of glass, thermoplastic resin such as cyclic polyolefin or polycarbonate, thermosetting resin, photocurable resin, UV curable resin or silicon. If thermoplastic resin such as cyclic polyolefin or polycarbonate is used, an injection molding method can be employed so that a substantial reduction in production costs is achieved. It is possible to use such a material to form a reflector. Then the surface is subjected to vapor deposition of metal such as aluminum or solver, whereby the reflection plane is formed.

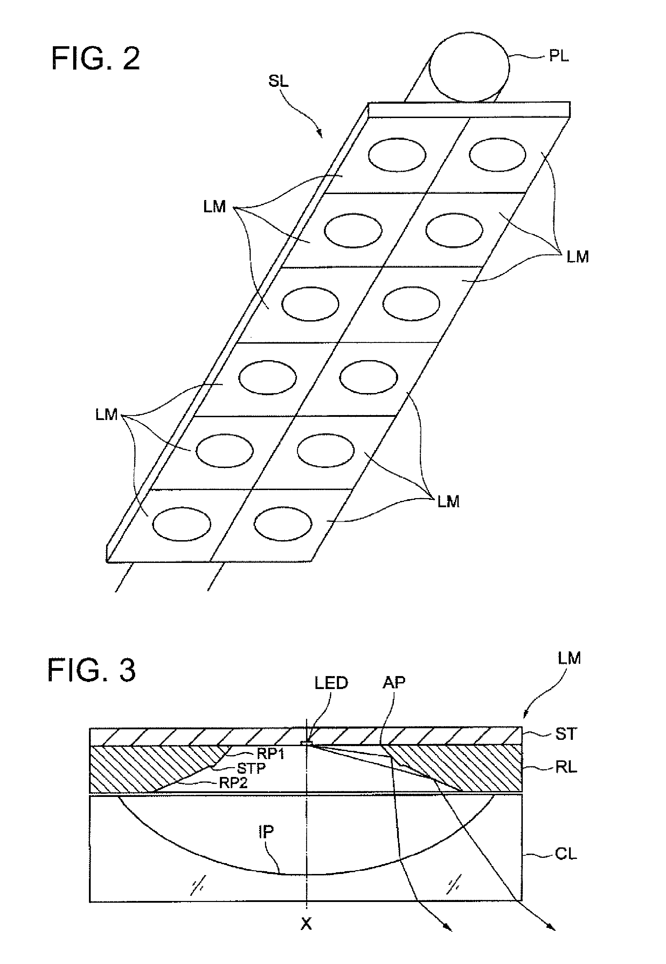

The reflector has a reflection plane for rejecting light emitted from an LED light source in the direction that goes away from the optical axis of the LED light source with respect to the direction parallel to the optical axis. To put it another way, the reflector has a reflection plane that reflects the light emitted from the LED light source in such a way that this light will be dispersed without being converged, as shown by the straight line in Fig 3. For convenience, the optical axis of the LED light source can be assumed as a line perpendicular to the plane surface of the LED chip af the LED light source.

The reflection plane for reflecting and diffusing the light is preferably formed in such a way that the inclination perpendicular to the direction of optical axis becomes less steep as one goes away from the LED light source in the direction perpendicular to the optical axis. Such a reflecting surface can be exemplified by the following two types.

1) A reflecting surface formed of a curved surface.

2) A reflecting surface consisting of a combination of a plurality of plane surfaces.

1) A reflecting surface formed of a curved surface is preferably a curved surface wherein, when a tangential in contact with the reflection plane is drawn, the angle formed by the tangential line and optical axis is increased as one goes away from the LED light source in the direction of optical axis, as shown by RP2 of Fig. 3, RP2 of Fig. 4, RP of Fig. 5 and RP2 of Fig. 6.

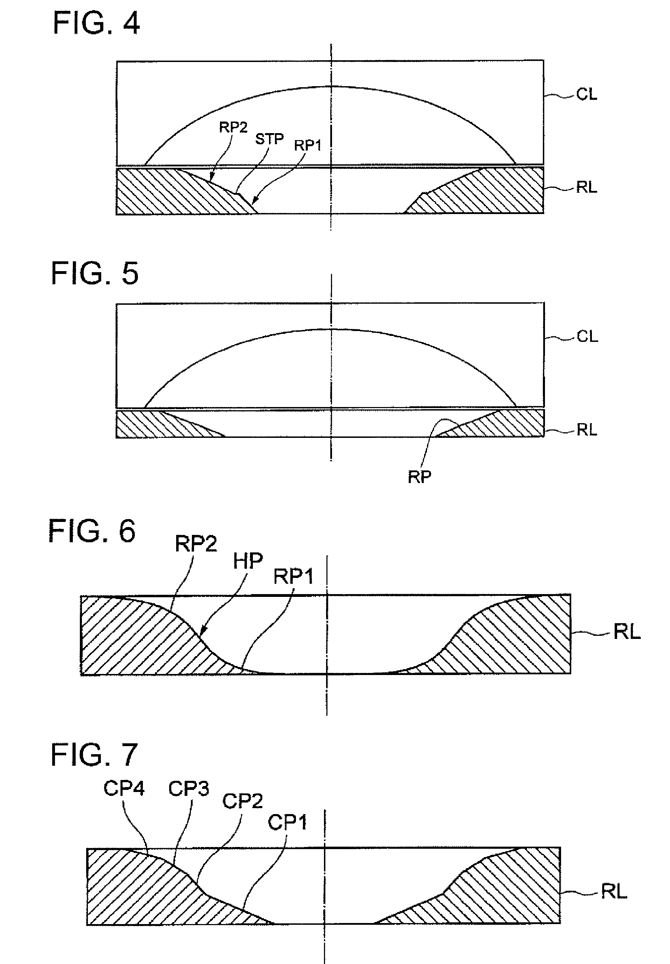

2) A reflecting surface consisting of a combination of a plurality of plane surfaces is preferably formed of a combination of a plurality of plane surfaces wherein the angle formed by the plane surface and optical axis is increased as one goes away from the LED light source in the direction of optical axis, as shown by CP2, CP3 and CP4 of Fig. 7.

The reflector can have a reflection plane for reflecting light in the direction parallel to the optical axis of the LED light source or in the direction coming closer to the optical axis with respect to the direction parallel thereto, in addition to the reflection plane for reflecting light in the direction that goes away from the optical axis with respect to the direction parallel to the optical axis of the LED light source. (This reflection plane is not always required to ensure that the entire light from the LED light source is reflected in the direction parallel to the optical axis of the LED light source or in the direction coming closer to the optical axis with respect to the direction parallel thereto. Part of the light from the LED light source may be reflected in the direction that goes away from the optical axis with respect to the direction parallel to the optical axis of the LED light source. This reflection plane preferably has a function of reflecting at least the light which is emitted from the LED light source, which has an outgoing angle of 80 degrees or more without exceeding 90 degrees with respect to the optical axis, and which has reached the reflection plane, in the direction that goes away from the optical axis of the LED light source with respect to the direction parallel to the optical axis, wherein the aforementioned outgoing angle can be 70 degrees or more without exceeding 90 degrees.) To be more specific, a reflection plane can be provided to ensure that the light emitted from the LED light source is reflected in the direction of optical axis or in the direction of being converged.

In the aforementioned reflection plane for reflecting the light in the direction parallel to the optical axis of the LED light source or in the direction coming closer to the optical axis with respect to the direction parallel thereto, the inclination of this plane preferably becomes steeper in the direction perpendicular to the optical axis, as one goes away from the LED light source in the direction perpendicular to the optical axis. In this case as well, this reflection plane may not be a curved surface, or may be composed of a combination of a plurality of plane surfaces, as shown by RP I of Fig. 6.

Since the light emitted from the LED light source is non-directional, the light can be almost perpendicular to the optical axis in some cases. When such light is reflected so as to come closer to the direction of optical axis, the efficiency of using light can be improved.

Accordingly, the reflection plane for reflecting the light in the direction parallel to the optical axis of the LED light source or in the direction coming closer to the optical axis with respect to the direction parallel thereto is preferably installed closer to the LED light source, than the reflection plane for reflecting light in the direction that goes away from the optical axis of the LED light source with respect to the direction parallel to the optical axis of the LED light source. To put it another way from the viewpoint of the shape, it is preferred that, on the side closer to the LED light source, the reflector should have a reflection plane whose inclination becomes steeper as one goes away from the LED light source in the direction perpendicular to the optical axis; whereas, on the side away from the LED light source, the reflector should have a reflection plane for reflecting light in the direction that goes away from the optical axis ofthe LED light source with respect to the direction parallel to the optical axis of the LED light source.

Further, it is also possible to adopt such a structure that, when the reflector is viewed from the direction perpendicular to the optical axis, the reflection plane has a step STP For example, it is preferred to have a step in the direction perpendicular to the optical axis or in the direction approximately perpendicular to the optical axis, as shown by the step STP of Fig. 3 and the step STP of Fig. 4. The term "approximately perpendicular to the optical axis" refers to an angle of 90 $\pm$ 10 degrees.

The aforementioned step is preferably provided between two reflection planes ofthe reflector which has, on the side closer to the LED light source, a reflection plane for reflecting light in the direction parallel to the optical axis of the LED light source or in the direction coming closer to the optical axis with respect to the parallel direction, and which has, on the side farther from the LED light source, a reflection plane for reflecting light in the direction going away from the optical axis with respect to the direction parallel to the optical axis of the LED light source. In this case, the step is preferably provided in such a way that the reflection plane for reflecting light to the side away from the optical axis with respect to the direction parallel to the optical axis of the LED light source goes farther away from the optical axis in the direction perpendicular to the optical axis, than the reflection plane for reflecting light in the direction parallel to the optical axis of the LED light source or in the direction coming closer to the optical axis with respect to the parallel direction. This step is preferably provided because the light emitted from the LED light source in the direction closer to the direction perpendicular to the optical axis can be converged more effectively and is utilized more efficiently, on the reflection plane for reflecting light in the direction parallel to the optical axis of the LED light source or in the direction coming closer to the optical axis with respect to the parallel direction; whereas the light that is emitted from the LED light source and is diffused at a proper angle to enter the diffusion lens directly can be diffused and reflected as required, without being reflected in an unwanted manner on the reflection plane for reflecting light in the direction going away from the optical axis with respect to the direction parallel to the optical axis of the LED light source.

Light emitted from the LED light source is found in various forms ranging from the light emitted in the direction of the optical axis to the light emitted in the direction perpendicular to the optical axis. As described above, the light emitted perpendicular to the optical axis is preferably reflected by the reflection plane in the direction parallel to the LED light source or in the direction coming closer to the optical axis with respect to the parallel direction. In the meantime, the reflector can be designed in such a shape that the light emitted in the direction 45 degrees or less with respect to the optical axis directly enters the diffusion lens without being reflected by the reflection plane. This configuration eliminates a loss in the quantity of light due to reflection. Accordingly, the loss in the quantity of light is preferably reduced. The loss in the quantity of light by reflection is further reduced if the reflector is designed in such a configuration that the light emitted in the direction wherein the angle with the optical axis is 60 degrees or less directly enters the diffusion lens without being reflected by the reflection plane. This angle can be 70 degrees or less.

A roughened surface is preferably formed between the LED light source and the reflection plane for reflecting light in the direction away from the optical axis with respect to the direction parallel to the optical axis of the LED light source. This preferably minimizes the color irregularities on the white LED composed of a blue LED chip and yellow fluorophore. The roughened surface in the sense in which it is used here refers to the microscopically roughened structure that has a higher surface roughness with respect to the mirror surface and scatters the light more easily, for example.

When the reflector has a step, the surface on the side of the LED light source from the step in the direction perpendicular to the optical axis (e.g., RP1 of Fig. 3 or RP 1 of Fig. 4) can be roughened. When a reflector has no step, it is possible to roughen the surface (e.g., RP1 of Fig. 6) wherein inclination in the direction perpendicular to the optical axis is steeper as one goes away from the LED light source in the direction perpendicular to the optical axis. It is also possible to roughen the surface of the reflector closest to the LED light source.

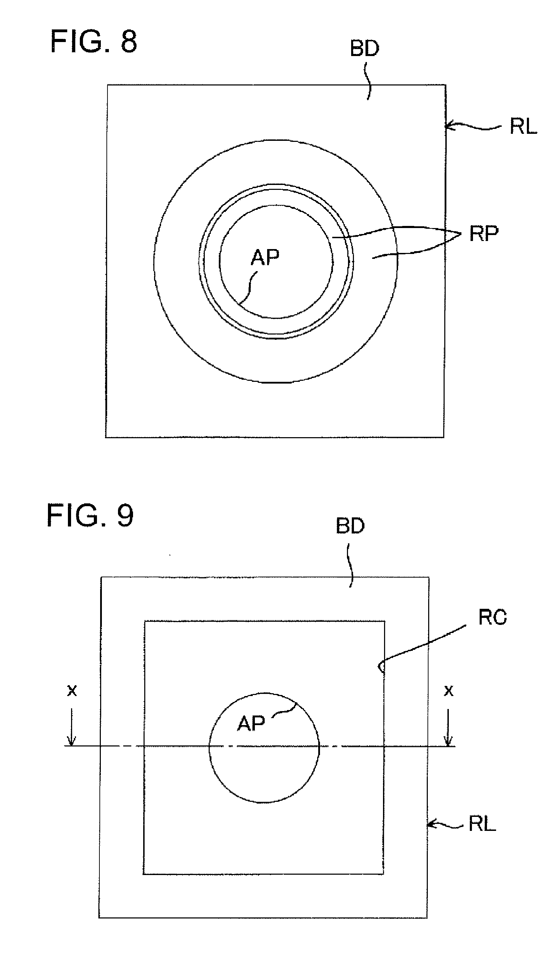

When viewed from the direction of the optical axis, the reflector is preferably formed in such a structure that a circular or elliptical reflection plane RP is arranged on a rectangular or square reflector body BD, as shown in Fig. 8. However, the present invention is not restricted thereto. In this case, all surfaces including the main body of the reflector can be provided with vapor deposition of aluminum or silver. Alternatively, only the circular or elliptical reflecting portion can be provided with vapor deposition of aluminum or silver. When viewed from the LED light source side in the direction of optical axis, this reflector is preferably formed so that the circular or elliptical aperture AP is visible, as shown in Fig. 9.

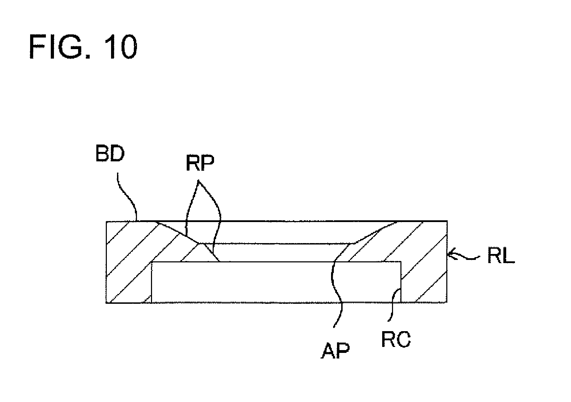

In another example of the reflector, it is also possible to provide a recess RC to be engaged with the chip of a LED light source, as shown in Fig. 10.

The following describes the diffusion lens.

The diffusion lens is defined as a lens for ensuring that the incoming light parallel to the optical axis is emitted as divergent light Preferred examples include a concave lens, diffraction lens and Fresnel lens. From the viewpoint of production, a concave lens is a preferred example.

The concave lens preferably has a concave surface on the side of the LED light source and a plain surface on the outside.

The reflector can be made of glass, thermoplastic resin such as cyclic polyolefin or polycarbonate, thermosetting resin, photocurable resin, UV curable resin or silicon. If thermoplastic resin such as cyclic polyolefin or polycarbonate is used, an injection molding method can be employed so that a substantial reduction in production costs is achieved.

The diffusion lens is preferably shaped in conformity to the reflector when viewed from the direction of the optical axis. For example, when the reflector is rectangular or square, the diffusion lens is preferably rectangular or square. However, the diffusion lens can be circular or elliptical in conformity to the reflection plane.

The reflector and diffusion lens are preferably overlapped with each other in the direction perpendicular to the optical axis, as shown in Fig. 3. In this case, the reflector and diffusion lens can be bonded by adhesive, or can be fitted by a fitting portion.

The thickness of at least one of the reflector and diffusion lens in the direction of the optical axis is preferably 1 mm or more without exceeding 20 mm. More preferably, the total thickness of the reflector and diffusion lens in the direction of the optical axis is 1 mm or more without exceeding 20 mm. When the advantage of the slim structure by use of a LED light source is to be effectively utilized, it is still more preferable that the total thickness of the reflector and diffusion lens in the direction of the optical axis is 1 mm or more without exceeding 10 mm.

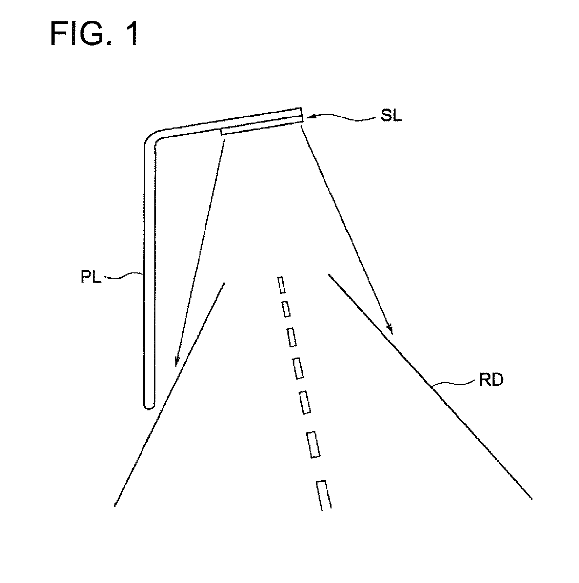

As shown in Fig. 2, a plurality of the LED light sources of the present invention are preferably installed flush with the plain surface so as to provide one illumination set A preferred application example is found in the street light or outdoor light wherein illumination over a wide range is desired, as has been revealed by the study of the present inventors. The street light can be installed on the pillar or on the ceiling or wall surface of a building and tunnel, as shown in Fig. 1.

**EFFECTS OF THE INVENTION**

The present invention provides a LED lighting device, street light and optical system for LED lighting device wherein the advantages of the slim structure of using a LED thinner than the incandescent light are further enhanced, and further expansion of the illumination range and effective use of outgoing light are ensured.

**BRIEF DESCRIPTION OF THE DRAWINGS**

Fig. 1 is a schematic view of a street light using a LED lighting device in an embodiment of the present invention;
Fig. 2 is a perspective view showing a LED lighting device used in a street light;
Fig. 3 is a cross sectional view of the LED lighting device;
Fig. 4 is a cross sectional view of a reflector in Example 1;
Fig. 5 is a cross sectional view of a reflector in Example 2;
Fig. 6 is a cross sectional view of a reflector in a Variation;
Fig. 7 is a cross sectional view of a reflector in another Variation;
Fig. 8 is a diagram showing a reflector as viewed from the outgoing side in the direction of the optical axis;
Fig. 9 is a diagram showing another reflector as viewed from the incoming side in the direction of the optical axis; and
Fig. 10 is a diagram showing the reflector of Fig. 9 as viewed from the direction of arrow X-X.

**DETAILED DESCRIPTION OF THE PREFERRED EMBODIMENTS**

The following describes the embodiments of the present invention with reference to the drawings. Fig. 1 is a schematic view of a street light using a LED lighting device in an embodiment of the present invention. Fig. 2 is a perspective view showing a LED lighting device used in a street light. Fig. 3 is a cross sectional view of the LED lighting device.

In Fig. 1, a street light SL is arranged on the top end of the hook-shaped pillar PL installed on the side of the road RD. As shown in Fig. 2, the street light SL is composed of a LED lighting device LM of two columns by six rows. However, the LED lighting device LM can be arranged in various forms of column-row matrix, without being restricted to the 2-column by 6-row matrix.

In Fig. 3, the LED lighting device LM includes a substrate ST with LED lighting device, reflector RL, and concave lens CL which are overlapped in that order. A light emitting diode LED as a LED light source is installed on the lower surface of the substrate ST installed on the pillar PL, and is connected to a drive circuit (not illustrated). A reflector RL is mounted on the substrate ST. The thin flat plate-shaped reflector RL is provided with a tapering aperture AP whose diameter is smaller on the side of the light emitting diode LED. A reflection plane is formed on the lateral surface of the aperture AP. To put it more specifically, the reflector RL has a first reflection plane RP1 closer to the light emitting diode LED, a second reflection plane RP2 farther from the light emitting diode LED, and a step STP that horizontally connects the bottom end of the first reflection plane RP1 with the top end of the second reflection plane RP2. To put it another way, the top end of the second reflection plane RP2 is shifted outside in the direction perpendicular to the optical axis with respect to the bottom end of the first reflection plane RP 1.

The average tilting angle of the first reflection plane RP1 in the direction perpendicular to the optical axis is greater than that of the second reflection plane RP2 in the direction perpendicular to the optical axis. Further, the reflection plane RP 1 and/or second reflection plane RP2 is shown as a curve in the cross sectional view of Fig. 3. In a preferred configuration, the inclination in the direction perpendicular to the optical axis is less steep as one goes away from the light emitting diode LED in the direction perpendicular to the optical axis. The reflector RL is formed by resin injection molding. This is followed by the step of applying aluminum vapor deposition or other processing to the first reflection plane RP 1, step STP and second reflection plane RP2, whereby the reflector RL is produced. (This applies to the cases of Examples and Variations to be introduced below).

The concave lens CL is formed by the resin injection molding operation. The light outgoing side is a plane surface wherein contamination of dust or dirt can be easily removed by washing. A concave incoming plane IP is formed on the light incoming slide. The reflector RL and concave lens CL constitute an optical system for the LED lighting device.

In the present embodiment, of the light emitted from the light emitting diode LED, the peripheral light emitted at a shallowest angle at the position farthest from the optical axis is reflected by the first reflection plane RP1, and is led toward the center of the concave incoming plane IP of the concave lens CL. This ensures an effective use of the peripheral light emitted from the light emitting diode LED, and covers a shortage in the characteristics of the light emitting diode LED of smaller brightness. In the meantime, the light emitted at the next shallowest angle is reflected by the second reflection plane RP2 and is led to the periphery of the light incoming plane IP of the concave lens CL. This arrangement increases the light diffusion effect over that in the case of using the concave lens CL alone. The illumination range can be expanded substantially by the increased intensity of the peripheral light out of the light emitted from the LED lighting device. Further, the curvature radius of the light incoming plane IP of the concave lens CL can be increased by the diffusion effect ofthe reflector RL. This provides a slim structure ofthe concave lens CL and plane surface of the light outgoing side, with the result that each of the thicknesses of the reflector RL and concave lens CL in the direction of the optical axis can be reduced by 1 through 20 mm.

**EXAMPLES**

The following describes the Examples of the reflector that can be used in the aforementioned embodiments. The reflection plane ofthe reflector is formed into an axially symmetric aspherical surface around the optical axis, which is defined by the mathematical expression obtained by substituting the coefficient of the Table into the following aspherical surface expression.

[Aspherical surface expression]

$$z = (Y^2/R)/[1+\sqrt{\{1-(K+1)(y/R)^2\}}] + A_1 y + A_2 Y^3 + A_4 y^4 + A_5 y^5 + A_6 y^6 + A_7 y^7 + A_8 y^9 + A_{10} Y^{10}$$
$$+ A_{11} y^{11} + A_{12} y^{12} + A_{13} y^{13} + A_{14} y^{14} + A_{15} Y^{15} + A_{16} Y^{16} + A_{17} Y^{17} + A_{18} Y^{18} + A_{19} Y^{19} + A_{20} Y^{20}$$

wherein
z: Aspherical surface (distance in the direction of optical axis from the vertex of surface of the aspherical surface
y: Distance from optical axis
R: Curvature radius
K: Korenich coefficient
$A_1$ through $A_{20}$: Aspherical surface coefficient
In the following description (including the data of Table), E (e.g., 2.5 x E -3) will be used to represent the power multiplier of 10 (e.g., $2.5 \times 10^{-3}$).

(Example 1)

Table 1 shows the data of Example 1. Fig. 4 is a cross sectional view of a reflector and concave lens in Example 1. The reflector of Example 1 includes a first reflection plane RP1 of the aspherical surface shown in Table 1, a step STP and a second reflection plane RP2 of the aspherical surface shown in Table 1. The step STP is a plane surface perpendicular to the optical axis.

[Table 1]

| RP2 (odd-ordered aspherical surface) | |
|---|---|
| R | 0.000 |
| K | 0.000 |
| A1 | -6.84733E-01 |
| A2 | -2.67197E-03 |
| A3 | 0.00000E+00 |
| A4 | 5.54673E-04 |
| A5 | 0.00000E+00 |
| A6 | 0.00000E+00 |
| A7 | 0.00000E+00 |
| A8 | 0.00000E+00 |
| A9 | 0.00000E+00 |
| A10 | 0.00000E+00 |

(continued)

| RP2 (odd-ordered aspherical surface) | |
|---|---|
| A11 | 0.00000E+00 |
| A12 | 0.00000E+00 |
| A13 | 0.00000E+00 |
| A14 | 0.00000E+00 |
| A15 | 0.00000E+00 |
| A16 | 0.00000E+00 |
| A17 | 0.00000E+00 |
| A18 | 0.00000E+00 |
| A19 | 0.00000E+00 |
| A20 | 0.00000E+00 |
| RP1 (aspherical surface) | |
| R | 2.000 |
| K | -1.000 |
| A1 | 0.00000E+00 |
| A2 | 0.00000E+00 |
| A3 | 0.00000E+00 |
| A4 | -3.00000E-03 |
| A5 | 0.00000E+00 |
| A6 | 0.00000E+00 |
| A7 | 0.00000E+00 |
| A8 | 0.00000E+00 |
| A9 | 0.00000E+00 |
| A10 | 0.00000E+00 |
| A11 | 0.00000E+00 |
| A12 | 0.00000E+00 |
| A13 | 0.00000E+00 |
| A14 | 0.00000E+00 |
| A15 | 0.00000E+00 |
| A16 | 0.00000E+00 |
| A17 | 0.00000E+00 |
| A18 | 0.00000E+00 |
| A19 | 0.00000E+00 |
| A20 | 0.00000E+00 |

(Example 2)

Table 2 shows the data of Example 2. Fig. 5 is a cross sectional view of the reflector and concave lens of Example 2. The reflector of Example 2 has a reflection plane RP of aspherical surface wherein the inclination in the direction perpendicular to the optical axis becomes less steep as one goes away from the center in the direction perpendicular to the optical axis. The reflector of Example 2 has such an advantage that the reflector of Example 1 can be designed in a slim structure.

[Table 2]

| RP(odd-ordered aspherical surface) | |
|---|---|
| R | 0.000 |
| K | 0.000 |
| A1 | -6.84733E-01 |
| A2 | -2.67197E-03 |
| A3 | 0.00000E+00 |
| A4 | 5.54673E-04 |
| A5 | 0.00000E+00 |
| A6 | 0.00000E+00 |
| A7 | 0.00000E+00 |
| A8 | 0.00000E+00 |
| A9 | 0.00000E+00 |
| A10 | 0.00000E+00 |
| A11 | 0.00000E+00 |
| A12 | 0.00000E+00 |
| A13 | 0.00000E+00 |
| A14 | 0.00000E+00 |
| A15 | 0.00000E+00 |
| A16 | 0.00000E+00 |
| A17 | 0.00000E+00 |
| A18 | 0.00000E+00 |
| A19 | 0.00000E+00 |
| A20 | 0.00000E+00 |

Fig. 6 is a cross sectional view of a reflector in a Variation. In the reflector RL of Fig. 6 wherein the inflection point HP is assumed as a boundary, a curved reflection plane RP1 is the reflection plane whose side closer to the light sources is concave, while a curved reflection plane RP2 is the reflection plane whose side farther from the light source is convex.

Fig. 7 is a cross sectional view of a reflector in another Variation. In the reflector RL of Fig. 7, the reflection plane is discontinuously formed by connection of four conical reflection planes CP1, CP2, CP3 and CP4, wherein angles are different from one another.

In the reflector RL of Fig. 6, the curved reflection plane RP1 closest to the light source can be the roughened surface, whereas the conical reflection plane CP1 closest to the light source can be the roughened surface in the reflector RL of Fig. 7. This arrangement reduces the color irregularties of the outgoing light from the LED lighting device LM by the light scattered from this roughened surface. A roughened surface in the reflector of Figs. 4 and 5 can also be installed close to the light source.

## INDUSTRIAL FIELD OF APPLICATION

The LED lighting device of the present invention can also be used as an indoor light, without the application being restricted to the street light Several reflectors and concave lenses can be molded in one operation, for example, as illustrated in Fig. 2. The roughened surface can be formed separately from the reflector.

**DESCRIPTION OF REFERENCE NUMERALS**

| | |
|---|---|
| AP | Aperture |
| CL | Concave lens |
| CP1, CP2, CP3 and CP4 | Conical reflection planes |
| HP | Inflection point |
| IP | Incoming plant |
| LED | Light emitting diode |
| LM | LED lighting device |
| PL | Pillar |
| RC | Recess |
| RD | Road |
| RL | Reflector |
| RP1 | First reflection plane |
| RP2 | Second reflection plane |
| SL | Street light |
| ST | Substrate |
| STP | Step |
| X | Optical axis |

**Claims**

1.  An LED lighting device comprising:

    an LED light source;
    a reflector for reflecting light emitted from the LED light source; and
    a diffusion lens for diffusing and emitting the light reflected by the reflector,
    wherein the reflector includes a reflection plane for reflecting light emitted from the LED light source toward a side going away from an optical axis of the LED light source with respect to a direction parallel to the optical axis.

2.  The LED lighting device described in Claim 1, wherein the reflector includes a reflection plane whose inclination with respect to a direction perpendicular to the optical axis becomes less steep as going away from the LED light source in the direction perpendicular to the optical axis.

3.  The LED lighting device descried in Claim 1 or Claim 2, wherein a roughened surface is formed between the LED lighting device and the reflection plane.

4.  The LED lighting device described in any one of Claims 1 through 3, wherein the reflection plane is formed of a curved surface.

5.  The LED lighting device described in any one of Claims 1 through 3, wherein the reflection plane is formed of a combination of a plurality of plane surfaces.

6.  The LED lighting device described in any one of Claims 1 through 5, wherein the diffusion lens is a concave lens.

7.  The LED lighting device described in Claim 6, wherein a thickness of at least one of the reflector and the concave lens in the direction of the optical axis is 1 mm or more without exceeding 20 mm.

8.  A street lamp comprising a plurality of LED lighting devices described in any one of Claims 1 through 7.

9.  An optical system used in an LED lighting device comprising: an LED light source; a reflector for reflecting light emitted from the LED light source; and a diffusion lens for diffusing and emitting light reflected by the reflector, wherein the optical system is provided with the reflector and the diffusion lens and the reflector has a reflection plane for reflecting light emitted from the LED light source toward a side going away from an optical axis of the LED light source with respect to a direction parallel to the optical axis.

FIG. 1

## FIG. 2

## FIG. 3

FIG. 4

FIG. 5

FIG. 6

FIG. 7

FIG. 8

FIG. 9

FIG. 10

**INTERNATIONAL SEARCH REPORT**

| International application No. |
| --- |
| PCT/JP2010/061880 |

A. CLASSIFICATION OF SUBJECT MATTER
*F21S8/08*(2006.01)i, *F21V13/04*(2006.01)i, *F21Y101/02*(2006.01)n

According to International Patent Classification (IPC) or to both national classification and IPC

B. FIELDS SEARCHED

Minimum documentation searched (classification system followed by classification symbols)
F21S8/08, F21V13/04, F21Y101/02

Documentation searched other than minimum documentation to the extent that such documents are included in the fields searched
Jitsuyo Shinan Koho          1922-1996    Jitsuyo Shinan Toroku Koho   1996-2010
Kokai Jitsuyo Shinan Koho    1971-2010    Toroku Jitsuyo Shinan Koho   1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 3143874 U  (Kan'yu Nogen Kagi Kofun Yugen Koshi), 07 August 2008 (07.08.2008), fig. 4; paragraph [0002] (Family: none) | 1-9 |
| Y | JP 10-083709 A  (Toshiba Lighting & Technology Corp.), 31 March 1998 (31.03.1998), fig. 17, 19 (Family: none) | 1-9 |
| Y | JP 3144220 U  (Yugen Kaisha Ato Miyajima), 21 August 2008 (21.08.2008), fig. 3 (Family: none) | 2 |

☐ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 29 July, 2010 (29.07.10) | 10 August, 2010 (10.08.10) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008130393 A
- JP 2008231218 A